# EUROPEAN PATENT APPLICATION

(11) **EP 4 625 093 A2**
(43) Date of publication of application: **01.10.2025**
(21) Application number: 25159188.9
(22) Date of filing: 20.02.2025
(51) Int. Cl.: G05F 1/571, G05F 1/595

(54) **VOLTAGE REGULATOR**

(30) Priority: 28.03.2024 US 202418619779
(71) Applicant: INTEL Corporation, Santa Clara, CA 95054 (US)
(72) Inventor: ZELIKSON, Michael, 3499569 Haifa (IL); GIL, Lior, 3542002 Haifa (IL); LURIA, Kosta, 42815 Pardesiya (IL); YUFFE, Marcelo, 30500 Binyamina (IL)
(74) Representative: HGF

(57) **Abstract**

Disclosed are techniques for protecting power stage transistors during inactive modes to limit voltage drops there across.

## Description

### TECHNICAL FIELD

Embodiments of the invention relate to the field of transistor reliability; and more specifically, to the field of circuits for power stage transistor stacks.

### BRIEF DESCRIPTION OF THE DRAWINGS

The disclosure may best be understood by referring to the following description and accompanying drawings that are used to illustrate embodiments of the invention. In the drawings:
Fig. 1 illustrates a multi-stack power stage in accordance with some embodiments.
Fig. 2 is a block diagram showing a multi stack DVR having power stage drop control in accordance with some embodiments.
Fig. 3 is a schematic diagram showing an integrated circuit (IC) package in accordance with some embodiments.
Fig. 4 is a flow diagram showing a routine for controlling a DVR output supply node voltage in accordance with some embodiments.
Fig. 5 is a circuit diagram showing a bias generation circuit in accordance with some embodiments.
Fig. 6 is a circuit diagram showing a DVR with power stage drop regulation in accordance with some embodiments.
Fig. 7 illustrates an example computing system in accordance with some embodiments.
Fig. 8 is a block diagram of an example processor that may have one or more cores and an integrated memory controller in accordance with some embodiments.

### DETAILED DESCRIPTION

Integrated digital voltage regulators can play an important role in integrated circuit (IC) power delivery networks, serving among other things as local regulation agents for power domains within an IC module. This can be valuable not only for power and performance, but also, for operational capabilities.

Digital voltage regulators, which include digital linear voltage regulators (DLVRs) and digital low drop-out (DLDO) voltage regulators, typically include a digitally controllable power stage coupled between an input supply voltage (Vsin) node and an output supply (Vsout) node that is usually lower than the input supply. The power stage usually includes a combination of one or more power gate transistors that may be digitally controlled to modulate the overall power stage resistance in response to changes in output load demand in order to maintain the output voltage (Vsout) at a regulated target voltage level. Combinations of the power gate transistors are controlled to either be in either an off (high impedance) or an On (low impedance) state. In many implementations, P type metal oxide semiconductor (MOS) transistors are used as the power gate transistors, but in some embodiments, N type MOS transistors may also or alternatively be employed.

Unfortunately, as process nodes advance and transistor dimensions become smaller, the power gate transistors (or simply power gates) become ever more susceptible to reliability issues resulting from electrical over stress (EOS) and excessive power and heating effects. Accordingly, tighter restrictions may be placed on the allowable input supply voltage (Vsin) and/or the allowed voltage drop (Vdrop) across the power stage and hence, may limit the performance of the DVR. At the same time, however, product designers may desire higher operational supply voltages that are able to rise above such limitations. Higher nominal voltages, as well as even higher so-called burst-mode voltages, are desired. Accordingly, in some embodiments, multi-transistor power gate stacks may be employed to withstand the higher Vsin-Vsout drops across the utilized power stages.

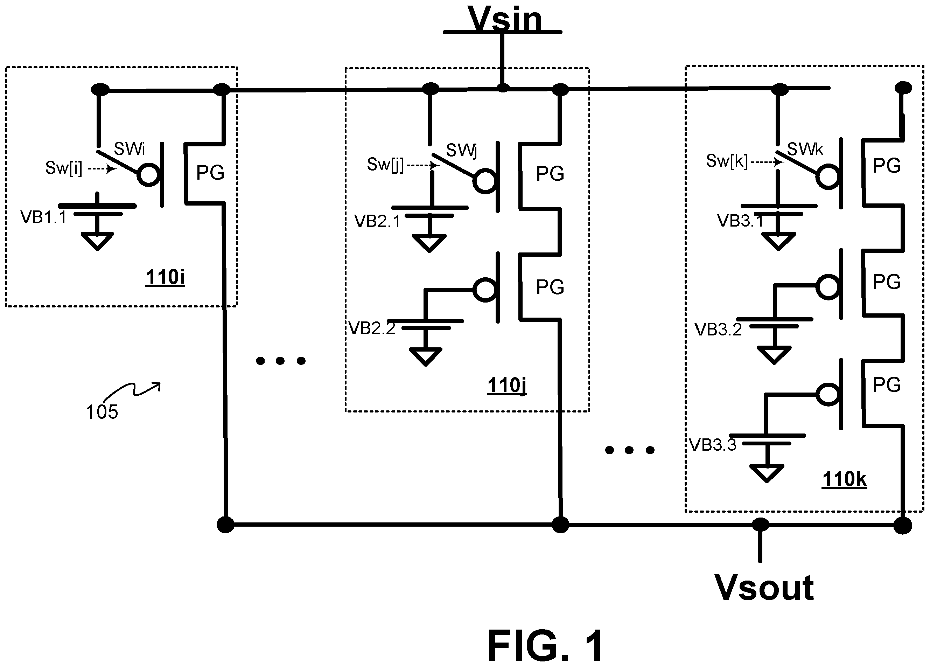

Fig. 1 illustrates a multi-stack power stage (PS) 105 in accordance with some embodiments. The power stage 105 includes a combination of power gate (PG) stacks 110 each formed from at least one transistor. In the depicted embodiment, P type MOS transistors are used as the power gate (PG) transistors with 1-transistor (110i), 2-transistor (110j), and 3-transistor (110k) stacks being used. (Note that as used herein, the term multi stack power stage refers to a power stage having any combination of power gate stacks each having at least one transistor. This could include power stages having stacks with the same numbers of transistors or with different numbers of transistors.)

In the depicted embodiment, the power stage 105 includes one or more one-transistor stacks (110i), one or more two-transistor stacks (110j), and one or more three-gate stacks (110k), coupled as shown between an input supply node (Vsin) and an output supply node (Vsout). Each stack 110 has an associated control switch (SWi, SWj, or SWk) to switch one of its transistor's gates to either its source, to turn if off, or to a gate bias voltage (VB) for an on mode. In the depicted embodiment, the top transistor in each stack is used for this purpose. Note that when a high impedance state is desired, all transistors may be driven to the non-condacting mode by connecting their gate terminals (VB2.2, VB3.2 and VB3.3) to Vsin.

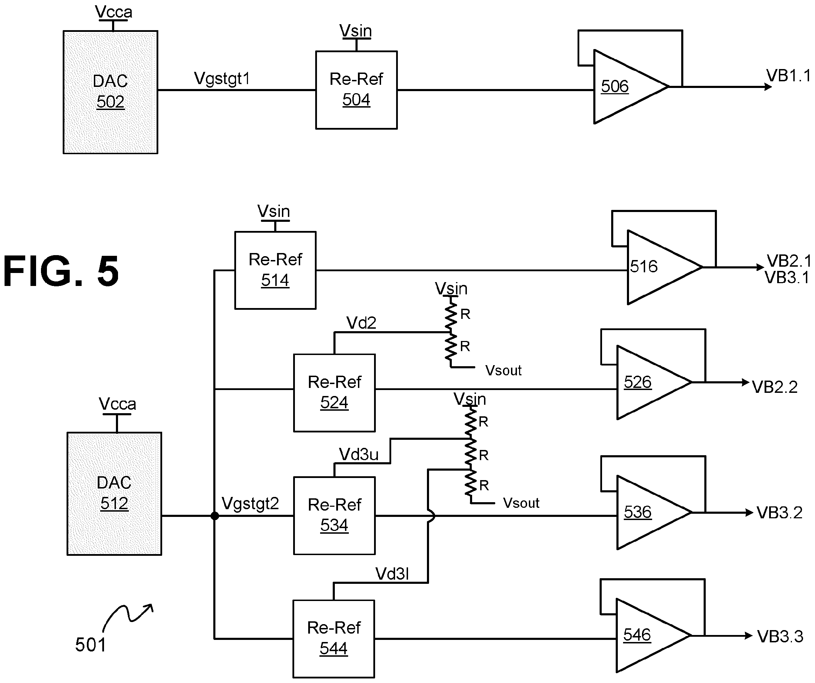

A control signal (Sw[i]) controls switch SWi to couple the single-stack transistor gate(s) either to a bias voltage (VB1.1) or to its associated source, which in this example is connected to the input supply (Vsin). Similarly, a control signal (Sw[j]) controls switch SWj to couple the two-stack upper transistor gate(s) either to a bias voltage (VB2.1) or to an associated source terminal; and a control signal (Sw[k]) controls switch SWk to couple the three-stack upper transistor gate(s) either to a bias voltage (VB3.1) or to an associated source terminal. In the depicted embodiment, the gates of the other, non upper, transistors in the multi transistor stacks (110j, 110k) are coupled to associated bias sources (VB2.2, VB3.2, VB3.3) to bias them at appropriate levels when the power stage is in an active mode. They are used to address the excessive stress risk. These biases can be constant, or Vsin dependent, or even depend on the level of the current that passes through the DVR power stage. In addition, they may be switchable between On levels and off levels. (An exemplary bias generation circuit with Vsin dependent bias levels is shown below in Fig. 5.)

In some embodiments, combinations of differently sized stacks are used as a trade-off between higher reliability, attained with multi-transistor stacks, and the significantly smaller area required for equivalently resistant single transistor stacks. That is, in order to achieve equivalent resistance (drive strength) in a multi transistor stack, as with a single transistor stack (assuming they use equivalent transistors), a substantially increased amount of power stage area is required. For example, an equivalently resistant two-transistor stack requires 4x larger area than a single transistor stack, and an equivalently resistant three-transistor stack requires 9X larger area than the single transistor stack.

To maintain the output voltage at the desired output supply level, a control unit dynamically changes the effective resistance of the power stage 105 by switching On and Off various stacks 110. Depending on a particular implementation, a variety of different approaches may be used for controlling the stacks. For example, any suitable coding scheme such as thermometer, binary, or a combination of both thermometer and binary coding may be used. For example, in some embodiments, an 8-bit control scheme may be employed. However, for power and routing complexity considerations, the most significant bits (e.g., bits<7:4>) may be translated into thermometer coded control units and the least significant bits (e.g., bits<3:0>) may be left as binary coded stack units. The power stage could thus be logically divided into 19 physical units, one per physical control line.

Similarly, the stacks may be individually controllable, or they may be grouped into commonly controllable units that consist of one or more separate stacks. In some embodiments, for example, when forms of thermometer coding are used, multi transistor stacks may be grouped together so that control bits of a power stage control vector each control power gate stacks of the same size (effective drive strength) even though their stack units may include different numbers of and differently sized transistor stacks.

It should be appreciated that under high dropout and low supply current conditions, the number of conducting transistors will be low, resulting in unacceptably high power and current densities for the individual stacks that are On. Under these conditions, only a few of the stack units, the least significant bit (LSB) stack units, are conducting. In some embodiments, the multi transistor stacks are used for these LSB stacks, while the smaller stacks (e.g., 1-transistor, 2-transistor) stacks are used for the most significant bit (MSB) stack units. In an example, four LSB stack units and three lower MSB stack units are implemented with 3-transistor stacks; seven middle MSB stack units are implemented with 2-transistor stacks; while the upper five MSB stack units are implemented with 1-transistor stacks. The DVR control circuitry is designed so that the 3-transistor stacks conduct over the whole drop-out range (e.g., up to 1100 mV), the 2-transistor stacks are operational for loads with drop-outs up to 500 mV, and the 1-transistor stacks are Off unless the drop-out is less than 250 mV. In this way, the most resilient higher stacks are exposed to the highest stress (high resistance, high drop-out) conditions while the smaller stacks are available to attain lowest possible resistance under high load conditions.

These approaches serve to adequately protect the smaller stacks when the DVR is active. However, if the DVR is in an inactive mode (e.g., stacks and biases are disabled) when the input supply (Vsin) is at its upper limits, the smaller stacks can be exposed to over-voltage damage. With the power stage in such an inactive mode (high impedance state), and with the gate-drain and source-drain voltages equal to Vsin - Vsout, the Vsout rail effectively floats at a non-deterministic level and can even drop to a near ground level and thus expose the single transistor stack transistor gate-source and drain sources to the high Vsin levels, which in many cases, can be higher than their allowed reliability limit (Vrel). Depending on the biasing voltages (even if active), similar reliability risks can be present in the larger (2-transistor or 3-transistor) stacks as well.

Accordingly, in some embodiments, a power stage (PS) voltage drop control circuit (or PS drop control circuit) is provided to maintain the output supply node (Vsout) at a sufficient level during an off state to maintain the PS drop below an allowed Vrel level.

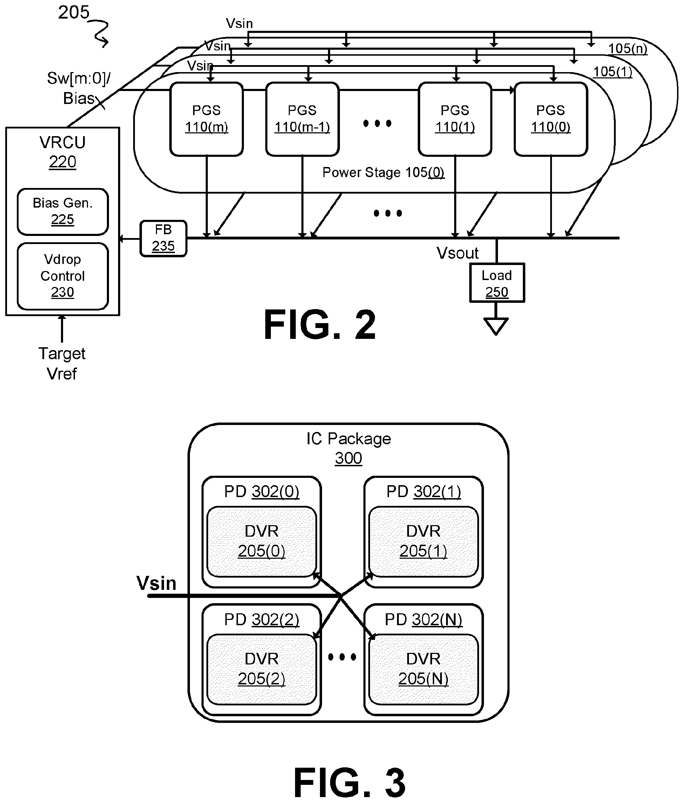

Fig. 2 is a block diagram showing a multi stack DVR 205 having PS drop control in accordance with some embodiments. The DVR generally includes a power stage array formed from at least one multi stack power stage(s) 105(0)-105(n), a voltage regulator control unit circuit (VRCU) 220, feedback sense circuitry 235, and a load 250, all coupled together as shown. The one or more power stage(s) 105 each include a plurality of power gate stacks (or stack units) 110(0)-110(m), as discussed above. In this example, the power stage array includes multiple power stages 105(1) through 105(n) since in some embodiments, multiple rows of power stages, coupled together across a power domain, may be employed in order to suitably source the required power demands in a balanced manner.

For active mode operation, the VR control unit 220 has closed loop control circuitry (not shown) to dynamically control the various power stage stacks 110, through switch control signals (Sw[m:0]), to be On or Off in order to control the overall power stage array impedance to regulate Vsout to be at, or at least suitably track, the target Vref voltage. In cooperation with feedback sense circuit 230, It may utilize one or more control loops, current, voltage, and/or other, for desired precision, stability, and responsiveness. The feedback sense circuit may include voltage dividers, voltage/current converters, and/or voltage/current/time converters to provide suitable feedback information to the active Vsout control circuitry within VRCU 220.

The VRCU 220 also has a bias generation circuit 225 and an Vdrop control circuit 230. The bias generation circuit 225, through bias signals coupled to the transistor gates in the power stage array, provides bias voltages to the transistors for them to be suitably on when their stacks are turned on and at the same time, allowing them to operate reliably. In some embodiments, they also may be used to control the On/Off states of the stack transistors in place of or in cooperation with the control switches. An example of a bias generation circuit is shown in Fig. 5 and discussed below.

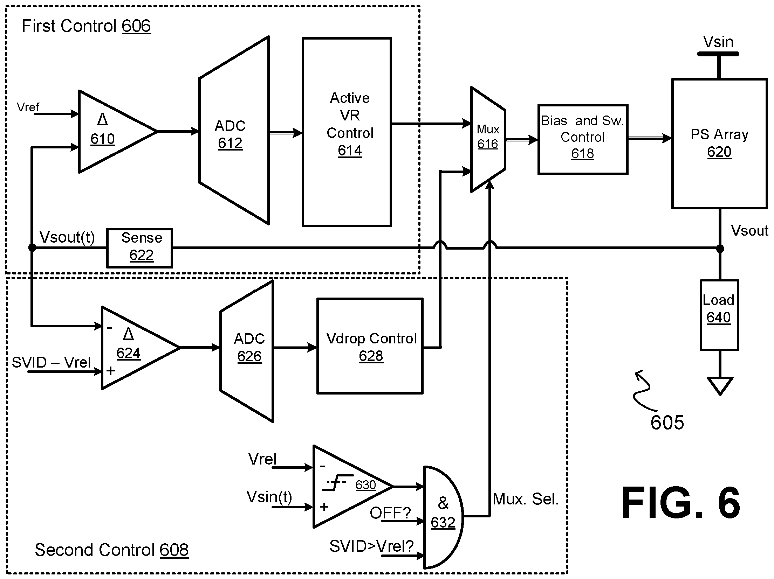

The Vdrop control circuit 230 controls the Vsout node during DVR high impedance (e.g., OFF) state so that it does not go below a voltage level that would otherwise damage the stack transistors, e.g. as a result of high Vsin voltage levels and near-ground Vsout levels if it were allowed to float or otherwise not be controlled. It may use part of the power stage array, e.g., one or more higher transistor stacks such as three-transistor stacks, or it may use separate stack(s) for controlling this voltage level. An example of an off-mode PS drop control circuit is shown in Fig. 6 and discussed below. Note that in some embodiments, separate control circuits may be used for active VR control and inactive PS Vdrop (through Vsout node) control for several different reasons. For example, the inactive control circuitry may be simpler and consume less power than the active VR control circuitry. Also, the regulated active Vsout may be designed to operate at a higher range (e.g., 500 to 1300 mV) as compared with the inactive PS drop control mode Vsout, which for example, may be designed to function within a lower range (e.g., 0 to 300 mV. With this situation, separate functional circuits such as analog amplifiers may be desired, one for the upper Vsout range and one for the lower Vsout range.

Fig. 3 is a schematic diagram showing an integrated circuit (IC) package 300 in accordance with some embodiments. This is a simplified view illustrating how multiple DVRs 205 may be used in an IC package to provide power to different power domains 302 within the package. The DVRs receive an input supply (Vsin), which may or may not be from off the package. Each DVR provides a regulated supply voltage to its associated power domain from this common input supply. This demonstrates why a DVR power stage may be in an Off mode while at the same time being exposed to a high supply input (Vsin) voltage.

The diagram also visually illustrates the concept of the power stage rows, if more than one is used, being distributed over the area occupied by its power domain. Remember, that physically, the DVR power stage array may constitute a mosaic of transistor stack units, arranged and connected in a way to achieve uniformity over the power delivery area. Accordingly, in some embodiments, different but equivalent and even possibly commonly connected power stage instantiations may be physically distributed over power domain load circuitry so as to reduce delivery losses and limit intolerable current densities within a given stack. They may or may not be spread over the domain evenly. For example, they may be disposed more densely or have higher portions of MSB stacks in higher current demand circuit areas.

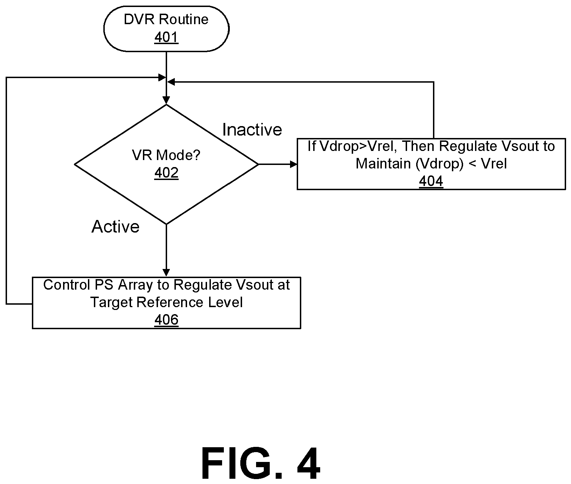

Fig. 4 is a flow diagram showing a routine 401 for controlling a DVR output supply node voltage in accordance with some embodiments. This routine, for example, may be performed by logical circuitry, e.g., finite state machine, one or more micro-controllers running firmware, dedicated logic circuit gates, and/or a combination of the same, by a voltage regulator control circuit such as control unit circuit 220 or by any other suitable combination of circuits in an IC package. At 402, the routine determines the mode of the VR being controlled. For example, it may determine if it is in an Off mode, where the power stage circuitry may be wholly or partially gated off, or if the VR is in an active mode, regulating an output supply Vsout, provided to a load, based on an input reference target level. If the VR is active, then at 406, the routine controls the power stage array to regulate the output (Vsout) at a value corresponding to the target reference (e.g., Vref).

On the other hand, if the DVR is inactive, then at 404, the routine regulates Vsout to maintain the drop-out level (Vdrop=Vsin-Vsout) to be less than Vrel, the reliability limit for the allowed Off-state drop-out across the power stage array. In some embodiments, it might do this when Vsin is larger than Vrel and otherwise allow the VR to be in a reduced power state, when Vsin is not larger than Vrel. An exemplary circuit for implementing an embodiment of this routine is shown in Fig. 6 and described below.

Fig. 5 is a circuit diagram showing a bias generation circuit in accordance with some embodiments. The bias generation circuit 501 generally includes digital-to-analog converters (DACs) 502, 512, re-reference (Reref) circuits 504, 514, 524, 534, 544, voltage dividers formed from resistors R, and analog buffers 506, 516, 526, 536, 546, all coupled together as shown. The circuit is configured to provide bias signals for 1, 2, and 3 transistor stacks such as for bias signals: VB1.1, VB2.1, VB3.1, VB2.2, VB3.2, and VB3.3 for the transistor stacks 110 of Figs 1 and 2. (As used herein, the term "re-ref" refers to a circuit to generate a transistor gate bias from an input supply and an input target where the gate bias provides a desired gate-source drop for the transistor. In some embodiments, the target is a target gate-source drop, and the input supply may vary and is also used for supplying power to the transistor, e.g., through its source. In some embodiments, the re-ref circuit may be a level shifting circuit to provide an output that corresponds to the input supply down-shifted by the input target value.)

The DACs, or non-volatile memory outside of the DACs, are programmed with tunable gate-source targets (Vgstgt1 and Vgstgt2) that are used by the re-ref circuits to generate suitable gate-source On biases for the stack transistors based on the level of the Vsin supply. (Remember that Vsin may vary over a relatively wide range, e.g., from a nominal level of 0.8 or 1.0 V to an extreme level of 1.8 V. In contrast, the DACs themselves are supplied with analog voltage supplies (Vcca), which can be greater or smaller than Vsin.)

DAC 502 provides a gate-source target (Vgstgt1) for the 1-transistor stacks, while DAC 512 provides a gate-source target (Vgstgt2) for the 2 and 3 transistor stacks. In some embodiments, the re-ref circuits may be configured to effectively down-shift the DVR supply input (Vsin) by the Vgs target values from the DACs. For example, they could be configured so that VB1.1 is equal to Vsin-Vgstgt1 and VB2.1 and VB3.1 are equal to Vsin-Vgstgt2. With this example, for the 1-stack transistors and top transistors from the multi-stacks, the actual gate-source bias levels will more reliably be at their respective gate-source target levels since their generated biases directly track Vsin by their target levels. The multi-stack lower transistor biases are also down-shifted by their associated gate-source targets (Vgstgt2), but from divided versions of the input supply (Vsin). With this scheme, VB2.2 will equal Vsin/2-Vgstgt2; VB3.2 will equal 2Vsin/3-Vgstgt2; and VB3.3 will equal Vsin/3-Vgstgt2. (It is assumed that the stacked transistors will operate with suitably equivalent resistances so the value of Vgstgt2 should closely correspond to the gate-source bias levels applied across the multi-stack transistors when they are On.)

Fig. 6 is a circuit diagram showing a DVR with PS drop regulation in accordance with some embodiments. DVR 605 generally includes a first control circuit 606, a second control circuit 608, multiplexer 616, Bias and Switch control circuitry 618, power stage array 620, and sense circuit 622, all coupled together as shown. The first control circuit 606 operates to generate a regulated supply at an output node (Vsout) for a load 640 during an active VR mode, while the second control circuit 608 operates to regulate the output node (Vsout) so that the PS drop (Vdrop) across the power stage(s) of a power stage array 620 stays below an acceptable level to avoid reliability issues during a VR off mode.

The first control circuit 606 includes a first analog difference (error) amplifier 610, a first analog-to-digital converter 612, and VR power stage (PS) control circuitry 614, all coupled as shown, to provide a regulated output supply (Vsout) for an active VR mode. In some embodiments, the analog components (first diff. amp. 610 and first ADC 612) may be designed to better operate over a first voltage range (e.g., 500 mV to 1300 mV) that corresponds to the active operation for providing the regulated output supply at Vsout.

With the depicted embodiment, the VR control circuit 614 is implemented with digital control circuitry, e.g., as discussed above with regard to Fig. 2. In operation, when the VR is in an active mode, the VR control circuit 614 dynamically controls on and off states of power stage stacks, or stack units, within the PS array 620 in response to a monitored difference between a target reference (Vref) and a sensed output (Vsout(t)) from sense circuit 622. The monitored difference (or error) is received from ADC 612, which digitizes the analog error signal from diff. amp. 610. The multiplexer (or mux.) 616 couples the VR control circuitry 614 to the bias and switch control circuit 618 when the VR is in an active mode.

The bias and switch control circuit 618 includes bias generation circuitry, as discussed, for example, with regard to Fig. 5, as well as switch control circuitry for controlling the On and Off states of the power gate transistors within the PS array 620 based on control signals from the PS control circuit 614. The switch control portion, for example, may include drivers for driving the power gate transistors when the control line network is large. In some embodiments, it may include routing and switches for bridging the logical control bit outputs from control circuit 614 to the physical transistors making up the PS array. It may also include switches for implementing different array configurations, such as for different power modes, loa demands or power saving off state modes.

The second control circuit 608 includes a second analog difference (error) amplifier 624, a second ADC 626, inactive mode Vdrop control circuit 628, comparator 630 and AND gate 632, all coupled together as shown. In some embodiments, the analog components (second diff. amp. 624 and second ADC 612) may be designed to better operate over a second voltage range (e.g., 0 mV to 500 mV) that corresponds to the inactive mode PS drop regulation for controlling Vsout to be at a value that suitably limits Vdrop across the power stage(s). For example, in some embodiments, the reliability limit (Vrel) may be a value in a range of between 1.1 and 1.5 V.

The AND gate 632 receives inputs from an OFF? signal, an SVID>Vrel signal, and an output from comparator 630, which indicates whether the monitored VR output (Vsout(t)) is greater than the Vrel limit. The Off? signal indicates whether the DVR is in an off state, de-asserting when it is in an active mode. The SVID term is a digital value corresponding to the system's requested target value for Vsin. Thus, the SVID>Vrel? indicates if the requested Vsin is larger than the PS reliability drop limit (Vrel). (Note that with the depicted embodiment, the SVID target value is used along with the monitored, actual Vsin value, because (1) they may be different due to non-idealized conditions, and (2) the digital SVID value may be conveniently monitored with a digital circuit, serving as an initial "warning" that the Vrel limit may be susceptible of being exceeded and allowing for the analog monitoring portion(s) to be inactive until the SVID is sufficiently high. (Note that the entire SVID value is not necessarily required. For example, a bit that defines if the target Vsin value exceeds Vrel may be sufficient.) In some embodiments, the SVID information may be available from the power management unit supplying the Vsin supply to the DVR domain.

In operation, when the DVR is in an active VR mode, the depicted OFF? signal is de-asserted, de-asserting AND gate 630 regardless of its other inputs, which in turn, causes MUX 816 to couple the VR control circuitry 614 to the switch and bias circuit 616, thereby coupling the active control output vector from VR control circuit 614 to the power stage array 620. This can allow for at least part of the second control circuitry to be in a reduced power mode under these conditions.

Similarly, even when the DVR is in an off state, with the OFF? signal asserting but when the domain SVID value doesn't exceed the Vrel value, then AND gate 632 again de-asserts and mux 616 again couples the VR control circuit 614 to the power stage array, although if the DVR is inactive (OFF? is asserted), the VR control circuit 614 may control the power stage 620 to be in an inactive, high-impedance state. With this scenario, the circuit analog portions may be power gated. This also will be the case, even when SVID is greater than Vrel, until Vsin(t) (the actual monitored Vsin value) becomes greater than Vrel. Until this happens, power stage control remains with the VR control circuit 614.

On the other hand, when the DVR is in an inactive mode (OFF asserted), the SVID exceeds Vrel, and Vsin(t) is greater than Vrel (comparator 630 asserts), then the mux. 616 will select the Vdrop control circuit 628, instead for control to be coupled to switch and bias circuit 618 to control the PS 620. Now, the Vdrop control circuitry 628 takes over in cooperation with diff. amp. 624 monitoring Vsin(t) and controls Vsout to be at SVID-Vrel), the level needed to maintain Vdrop below Vrel. In some embodiments, the transitions between active VR and Vdrop regulation modes are autonomous, and their durations may be of an order of several tens of nanoseconds and thus, excessive delay (e.g., on the timescale of power management flows) may be avoided.

It should be appreciated that with this approach, neither battery life, nor performance power budgets need be significantly impacted. During battery life scenarios, the SVID will most likely be relatively low (less than Vrel) with the PS drop regulation circuitry being powered down. The Vdrop regulation circuitry will typically be powered in the cases when some other domain requires an SVID (Vsin) that is higher than the reliability limit and the domain of interest is Off.

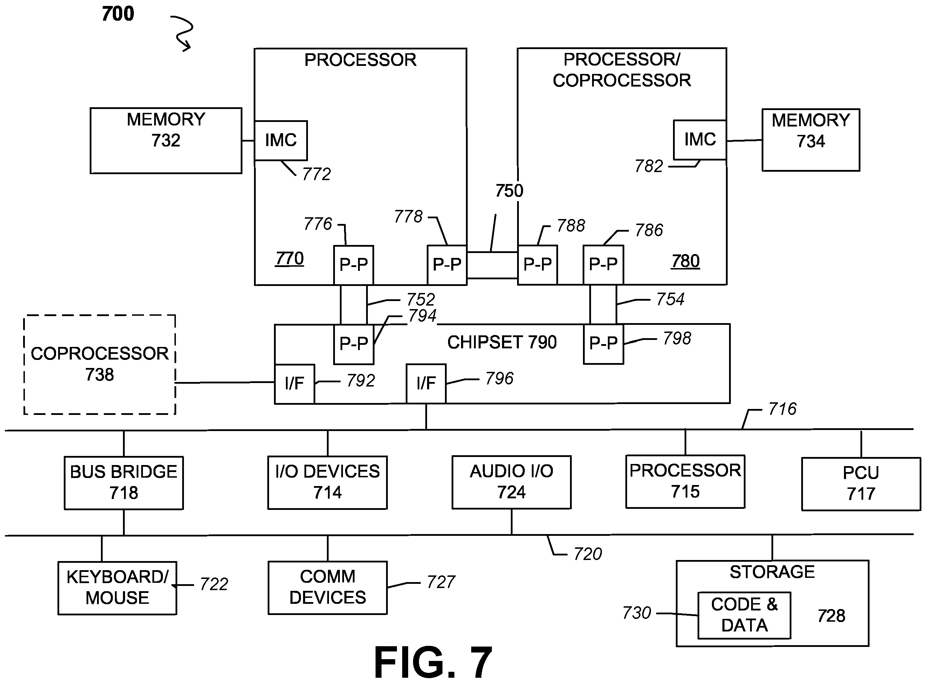

Fig. 7 illustrates an example computing system 700 in accordance with some embodiments. Multiprocessor system 700 is an interfaced system and includes a plurality of processors including a first processor 770 and a second processor 780 coupled via an interface 750 such as a point-to-point (P-P) interconnect, a fabric, and/or bus. In some examples, the first processor 770 and the second processor 780 are homogeneous. In some examples, first processor 770 and the second processor 780 are heterogenous. Though the example system 700 is shown to have two processors, the system may have three or more processors, or may be a single processor system. In some examples, the computing system is implemented, wholly or partially, with a system on a chip (SoC) or a multi-chip (or multi-chiplet) module, in the same or in different package combinations. Along these lines, it may include several different power domains such as is represented with respect to Fig. 3 with one or more DVRs in accordance with examples discussed above.

Processors 770 and 780 are shown including integrated memory controller (IMC) circuitry 772 and 782, respectively. Processor 770 also includes interface circuits 776 and 778, along with core sets. Similarly, second processor 780 includes interface circuits 786 and 788, along with a core set as well. A core set generally refers to one or more compute cores that may or may not be grouped into different clusters, hierarchal groups, or groups of common core types. Cores may be configured differently for performing different functions and/or instructions at different performance and/or power levels. The processors may also include other blocks such as memory and other processing unit engines.

Processors 770, 780 may exchange information via the interface 750 using interface circuits 778, 788. IMCs 772 and 782 couple the processors 770, 780 to respective memories, namely a memory 732 and a memory 734, which may be portions of main memory locally attached to the respective processors.

Processors 770, 780 may each exchange information with a network interface (NW I/F) 790 via individual interfaces 752, 754 using interface circuits 776, 794, 786, 798. The network interface 790 (e.g., one or more of an interconnect, bus, and/or fabric, and in some examples is a chipset) may optionally exchange information with a coprocessor 738 via an interface circuit 792. In some examples, the coprocessor 738 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 770, 780 or outside of both processors, yet connected with the processors via an interface such as P-P interconnect, such that either or both processors' local cache information may be stored in the shared cache if a processor is placed into a low power mode.

Network interface 790 may be coupled to a first interface 716 via interface circuit 796. In some examples, first interface 716 may be an interface such as a Peripheral Component Interconnect (PCI) interconnect, a PCI Express interconnect, or another I/O interconnect. In some examples, first interface 716 is coupled to a power control unit (PCU) 717, which may include circuitry, software, and/or firmware to perform power management operations with regard to the processors 770, 780 and/or co-processor 738. PCU 717 provides control information to one or more voltage regulators (such as any of the examples discussed above) to cause the voltage regulator(s) to generate the appropriate regulated voltage(s), e.g., a Vsin input supply for one or a plurality of DVRs as discussed above. In various examples, PCU 717 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 717 is illustrated as being present as logic separate from the processor 770 and/or processor 780. In other cases, PCU 717 may execute on a given one or more of cores (not shown) of processor 770 or 780. In some cases, PCU 717 may be implemented as a microcontroller (dedicated or general-purpose) or other control logic configured to execute its own dedicated power management code, sometimes referred to as P-code. In yet other examples, power management operations to be performed by PCU 717 may be implemented externally to a processor, such as by way of a separate power management integrated circuit (PMIC) or another component external to the processor. In yet other examples, power management operations to be performed by PCU 717 may be implemented within BIOS or other system software. Along these lines, power management may be performed in concert with other power control units implemented autonomously or semi-autonomously, e.g., as controllers or executing software in cores, clusters, IP blocks and/or in other parts of the overall system.

Various I/O devices 714 may be coupled to first interface 716, along with a bus bridge 718 which couples first interface 716 to a second interface 720. In some examples, one or more additional processor(s) 715, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 716. In some examples, second interface 720 may be a low pin count (LPC) interface. Various devices may be coupled to second interface 720 including, for example, a keyboard and/or mouse 722, communication devices 727 and storage circuitry 728. Storage circuitry 728 may be one or more non-transitory machine-readable storage media as described below, such as a disk drive or other mass storage device which may include instructions/code and data 730 and may implement the storage in some examples. Further, an audio I/O 724 may be coupled to second interface 720. Note that other architectures than the point-to-point architecture described above are possible. For example, instead of the point-to-point architecture, a system such as multiprocessor system 700 may implement a multi-drop interface or other such architecture.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

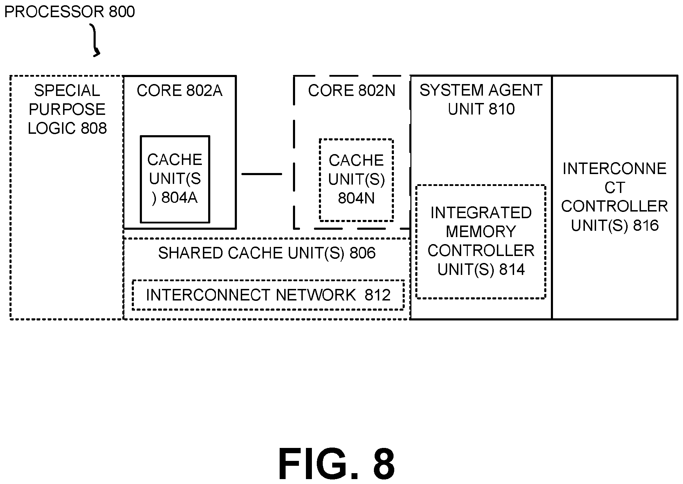

Fig. 8 illustrates a block diagram of an example processor and/or SoC 800 that may have one or more cores and an integrated memory controller in accordance with some embodiments. The solid lined boxes illustrate a processor 800 with a single core 802(A), system agent unit circuitry 810, and a set of one or more interface controller unit(s) circuitry 816, while the optional addition of the dashed lined boxes illustrates an alternative processor 800 with multiple cores 802(A)-(N), a set of one or more integrated memory controller unit(s) circuitry 814 in the system agent unit circuitry 810, and special purpose logic 808, as well as a set of one or more interface controller units circuitry 816. Note that the processor 800 may be one of the processors 770 or 780, or co-processor 738 or 715 of FIG. 7.

Thus, different implementations of the processor 800 may include: 1) a CPU with the special purpose logic 808 being integrated graphics and/or scientific (throughput) logic (which may include one or more cores, not shown), and the cores 802(A)-(N) being one or more general purpose cores (e.g., general purpose in-order cores, general purpose out-of-order cores, or a combination of the two); 2) a coprocessor with the cores 802(A)-(N) being a large number of special purpose cores intended primarily for graphics and/or scientific (throughput); and 3) a coprocessor with the cores 802(A)-(N) being a large number of general purpose in-order cores. Thus, the processor 800 may be a general-purpose processor, coprocessor or special-purpose processor, such as, for example, a network or communication processor, compression engine, graphics processor, GPGPU (general purpose graphics processing unit), a high throughput many integrated core (MIC) coprocessor (including 30 or more cores), embedded processor, or the like. The processor may be implemented on one or more chips. The processor 800 may be a part of and/or may be implemented on one or more substrates using any of a number of process technologies, such as, for example, complementary metal oxide semiconductor (CMOS), bipolar CMOS (BiCMOS), P-type metal oxide semiconductor (PMOS), or N-type metal oxide semiconductor (NMOS).

A memory hierarchy includes one or more levels of cache unit(s) circuitry 804(A)-(N) within the cores 802(A)-(N), a set of one or more shared cache unit(s) circuitry 806, and external memory (not shown) coupled to the set of integrated memory controller unit(s) circuitry 814. The set of one or more shared cache unit(s) circuitry 806 may include one or more mid-level caches, such as level 2 (L2), level 3 (L3), level 4 (L4), or other levels of cache, such as a last level cache (LLC), and/or combinations thereof. While in some examples interface network circuitry 812 (e.g., a ring interconnect) interfaces the special purpose logic 808 (e.g., integrated graphics logic), the set of shared cache unit(s) circuitry 806, and the system agent unit circuitry 810, alternative examples use any number of well-known techniques for interfacing such units. In some examples, coherency is maintained between one or more of the shared cache unit(s) circuitry 806 and cores 802(A)-(N). In some examples, interface controller units circuitry 816 couple the cores 802 to one or more other devices 818 such as one or more I/O devices, storage, one or more communication devices (e.g., wireless networking, wired networking, etc.), etc.

In some examples, one or more of the cores 802(A)-(N) are capable of multi-threading. The system agent unit circuitry 810 includes those components coordinating and operating cores 802(A)-(N). The system agent unit circuitry 810 may include, for example, power control unit (PCU) circuitry and/or display unit circuitry (not shown). The PCU may be or may include logic and components needed for regulating the power state of the cores 802(A)-(N) and/or the special purpose logic 808 (e.g., integrated graphics logic). The display unit circuitry is for driving one or more externally connected displays.

The cores 802(A)-(N) may be homogenous in terms of instruction set architecture (ISA). Alternatively, the cores 802(A)-(N) may be heterogeneous in terms of ISA; that is, a subset of the cores 802(A)-(N) may be capable of executing an ISA, while other cores may be capable of executing only a subset of that ISA or another ISA.

Illustrative examples of the technologies disclosed herein are provided below. An
embodiment of the technologies may include any one or more, and any compatible combination of, the examples described below.

Example 1 is an apparatus that includes a plurality of transistors, a first control circuit, and a second control circuit. The plurality of transistors is coupled between an input supply node and an output supply node. The first control circuit is coupled to the plurality of transistors to generate a regulated output voltage at the output supply node from an input supply voltage at the input supply node based on a reference voltage. The second control circuit is coupled to the output supply node to maintain a voltage drop across the plurality of transistors under a limit based on the first control circuit being in an inactive mode, e.g., when the first control circuit is not generating the regulated output voltage.

Example 2 includes the subject matter of example 1, and wherein the plurality of transistors include a power stage having at least one single-transistor stack.

Example 3 includes the subject matter of any of examples 1 and 2, and wherein the power stage includes at least one 2-transistor stack and at least one 3-transistor stack.

Example 4 includes the subject matter of any of examples 1-3, and wherein the plurality of transistors are part of a structure having a plurality of power stages including at least one 1-transistor stack, at least one 2-transistor stack, and at least one 3-transistor stack.

Example 5 includes the subject matter of any of examples 1-4, and wherein the first control circuit includes a first analog difference amplifier having an input coupled to the output supply node and an output coupled to an input of a first analog to digital converter (ADC).

Example 6 includes the subject matter of any of examples 1-5, and wherein the first analog difference amplifier input is coupled to the output supply node through a sense circuit.

Example 7 includes the subject matter of any of examples 1-6, and wherein the second control circuit includes a second analog difference amplifier having an input coupled to the output supply node and an output coupled to an input of a second analog to digital converter (ADC).

Example 8 includes the subject matter of any of examples 1-7, and wherein the second analog difference amplifier input is coupled to the output supply node through a second sense circuit.

Example 9 includes the subject matter of any of examples 1-8, and wherein the first difference amplifier has first circuit structure to operate on voltages within a first range, and the second difference amplifier has second circuit structure to operate on voltages within a second range that is at least 50% different from the first range.

Example 10 includes the subject matter of any of examples 1-9, and wherein the first range has a lower limit above 500 mV, and the second range has an upper limit below 500 mV.

Example 11 includes the subject matter of any of examples 1-10, and further includes a multiplexer to switch control of the plurality of transistors between the first and second control circuits.

Example 12 includes the subject matter of any of examples 1-11, and wherein the second control circuit is to maintain the voltage drop across the plurality of transistors under the limit when a monitored voltage difference between the input and output supply nodes is above the limit.

Example 13 includes the subject matter of any of examples 1-12, and wherein the second control circuit has a logic circuit to disable the second control circuit to maintain the voltage drop across the plurality of transistors unless a digital value associated with the input supply voltage is above a threshold.

Example 14 is an integrated circuit (IC) package having one or more IC dies and at least one digital voltage regulator in accordance with the subject matter of any of examples 1-13.

Example 15 is an apparatus that includes a digital voltage regulator circuit and a second control circuit. The digital voltage regulator circuit has an input supply node and an output supply node, a power stage having a plurality of transistor stacks coupled between the input and output supply nodes, the plurality of transistor stacks including at least one 1-transistor stack and at least one multi-transistor stack, and a first control circuit coupled to the plurality of transistor stacks to generate a regulated output supply voltage at the output supply node. The second control circuit is coupled to the output supply node to limit a voltage drop between the input and output supply nodes.

Example 16 includes the subject matter of example 15, and wherein the transistor stacks are grouped into 1-transistor stack units and multi-transistor stack units, the one and multi transistor stack units each having an input control bit that is part of a digital control value with bits ranging from a least significant bit to a most significant bit, wherein the most significant bit controls at least one of the 1-transistor stack units.

Example 17 includes the subject matter of any of examples 15-16, and wherein the least significant bit controls at least one of the multi-transistor stack units.

Example 18 includes the subject matter of any of examples 15-17, and wherein the first control circuit includes a first analog difference amplifier having an input coupled to the output supply node and an output coupled to an input of a first analog to digital converter (ADC).

Example 19 includes the subject matter of any of examples 15-18, and wherein the first analog difference amplifier input is coupled to the output supply node through a sense circuit.

Example 20 includes the subject matter of any of examples 15-19, and wherein the second control circuit includes a second analog difference amplifier having an input coupled to the output supply node and an output coupled to an input of a second analog to digital converter (ADC).

Example 21 includes the subject matter of any of examples 15-20, and wherein the second analog difference amplifier input is coupled to the output supply node through a second sense circuit.

Example 22 includes the subject matter of any of examples 15-21, and the first difference amplifier has first circuit structure to operate on voltages within a first range, and the second difference amplifier has second circuit structure to operate on voltages within a second range that is at least 50% different from the first range.

Example 23 includes the subject matter of any of examples 15-22, and wherein the first range has a lower limit above 500 mV, and the second range has an upper limit below 500 mV.

Example 24 includes the subject matter of any of examples 15-23, and further includes a multiplexer to switch control of the power stage between the first and second control circuits.

Example 25 includes the subject matter of any of examples 15-24, and wherein the second control circuit is to maintain the voltage drop across the plurality of transistors under the limit when a monitored voltage difference between the input and output supply nodes is above the limit.

Example 26 includes the subject matter of any of examples 15-25, and wherein the second control circuit has a logic circuit to disable the second control circuit to maintain the voltage drop across the plurality of transistors unless a digital value for the input supply voltage is above a threshold.

Example 27 is an integrated circuit (IC) package having at least one IC die with a plurality of power domains. It also has a plurality of voltage regulators coupled to the plurality of power domains. Each voltage regulator has an input supply node and an output supply node to provide a regulated voltage supply to an associated one of the plurality of power domains. Each voltage regulator includes a plurality of transistors coupled between its input supply node and its output supply node. Each voltage regulator also has a first control circuit and a second control circuit. The first control circuit is coupled to the plurality of transistors to generate the regulated output supply voltage at the output supply node from an input supply voltage at its input supply node based on a reference voltage for the voltage regulator. The second control circuit is coupled to the output supply node to maintain a voltage drop across the plurality of transistors under a limit when the first control circuit is not generating the regulated output voltage.

Example 28 includes the subject matter of example 27, and wherein the input supply nodes of the plurality of voltage regulators are coupled together at a common power supply node.

Example 29 includes the subject matter of any of examples 27-28, and wherein the plurality of transistors include a power stage having at least one single-transistor stack.

Example 30 includes the subject matter of any of examples 27-29, and wherein the power stage includes at least one 2-transistor stack and at least one 3-transistor stack.

Example 31 includes the subject matter of any of examples 27-30, and wherein the plurality of transistors are part of a structure having a plurality of power stages including at least one 1-transistor stack, at least one 2-transistor stack, and at least one 3-transistor stack.

Example 32 includes the subject matter of any of examples 27-31, and wherein the first control circuit includes a first analog difference amplifier having an input coupled to the output supply node and an output coupled to an input of a first analog to digital converter (ADC).

Example 33 includes the subject matter of any of examples 27-32, and wherein the first analog difference amplifier input is coupled to the output supply node through a sense circuit.

Example 34 includes the subject matter of any of examples 27-33, and wherein the second control circuit includes a second analog difference amplifier having an input coupled to the output supply node and an output coupled to an input of a second analog to digital converter (ADC).

Example 35 includes the subject matter of any of examples 27-34, and wherein the second analog difference amplifier input is coupled to the output supply node through a second sense circuit.

Example 36 includes the subject matter of any of examples 27-35, and wherein the first difference amplifier has first circuit structure to operate on voltages within a first range, and the second difference amplifier has second circuit structure to operate on voltages within a second range that is at least 50% different from the first range.

Example 37 includes the subject matter of any of examples 27-36, and wherein the first range has a lower limit above 500 mV, and the second range has an upper limit below 500 mV.

Example 38 includes the subject matter of any of examples 27-37, and further includes a multiplexer to switch control of the plurality of transistors between the first and second control circuits.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types such as carbon nanotubes or spintronic devices.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent upon the platform within which the present disclosure is to be implemented.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, a system on a chip (SoC), an application processor, an integrated circuit incorporating a combination of one or more of the aforesaid items, etc.

Note that in the corresponding drawings of the embodiments, signals are represented with lines. Some lines may be thicker, or include compound lines, to indicate more constituent signal paths, and/or have arrows at one or more ends, to indicate primary information flow direction. Such indications are not intended to be limiting or exclusive. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the spirit and scope of the appended claims. For example, for convenience, the power stages and power stage control have primarily been explained using the scheme of a DVR design, but the same principles are applicable to any digital power stage that uses power gate transistors whose voltage drops are to be limited during an unprotected, inactive state. In addition, while closed loop regulation has been presented for limiting voltage drops across power stages, open loop control could also be employed. The description is thus to be regarded as illustrative instead of limiting.

## Claims

1. An apparatus, comprising:
a plurality of transistors coupled between an input supply node and an output supply node;
a first control circuit coupled to the plurality of transistors to generate a regulated output voltage at the output supply node from an input supply voltage at the input supply node based on a reference voltage; and
a second control circuit coupled to the output supply node to maintain a voltage drop across the plurality of transistors under a limit when the first control circuit is not generating the regulated output voltage.

2. The apparatus of claim 1, wherein the plurality of transistors include a power stage having at least one single-transistor stack.

3. The apparatus of claim 2, wherein the power stage includes at least one 2-transistor stack and at least one 3-transistor stack.

4. The apparatus of any of claims 1-3, wherein the plurality of transistors are part of a structure having a plurality of power stages including at least one 1-transistor stack, at least one 2-transistor stack, and at least one 3-transistor stack.

5. The apparatus of claim 1 or claim 4, wherein the first control circuit includes a first analog difference amplifier having an input coupled to the output supply node and an output coupled to an input of a first analog to digital converter (ADC).

6. The apparatus of claim 5, wherein the first analog difference amplifier input is coupled to the output supply node through a sense circuit.

7. The apparatus of claim 5 or claim 6, wherein the second control circuit includes a second analog difference amplifier having an input coupled to the output supply node and an output coupled to an input of a second analog to digital converter (ADC).

8. The apparatus of claim 7, wherein the second analog difference amplifier input is coupled to the output supply node through a second sense circuit.

9. The apparatus of claim 7 or claim 8, wherein the first difference amplifier has first circuit structure to operate on voltages within a first range, and the second difference amplifier has second circuit structure to operate on voltages within a second range that is at least 50% different from the first range.

10. The apparatus of claim 9, wherein the first range has a lower limit above 500 mV, and the second range has an upper limit below 500 mV.

11. The apparatus of any of claims 1-10, comprising a multiplexer to switch control of the plurality of transistors between the first and second control circuits.

12. The apparatus of any of claims 1-11, wherein the second control circuit is to maintain the voltage drop across the plurality of transistors under the limit when a monitored voltage difference between the input and output supply nodes is above the limit.

13. The apparatus of claim 12, wherein the second control circuit has a logic circuit to disable the second control circuit to maintain the voltage drop across the plurality of transistors unless a digital value for the input supply voltage is above a threshold.

14. An integrated circuit (IC) package having one or more IC dies and at least one digital voltage regulator in accordance with the apparatus of any of claims 1-13.

15. A computer system, comprising the integrated circuit package of claim 14 coupled to an external power supply and a display.
